# EUROPEAN PATENT SPECIFICATION

(11) **EP 4 224 543 B1**
(45) Date of publication and mention of the grant of the patent: **09.04.2025**
(21) Application number: 22155617.8
(22) Date of filing: 08.02.2022
(51) Int. Cl.: H10N 30/076, H10N 30/853, C23C 14/06, C23C 14/02, C23C 14/28, C23C 14/34

(54) **METHOD FOR DEPOSITING HIGHLY DOPED ALUMINIUM NITRIDE PIEZOELECTRIC MATERIAL**
VERFAHREN ZUR ABSCHEIDUNG VON PIEZOELEKTRISCHEM MATERIAL AUS HOCHDOTIERTEM ALUMINIUMNITRID
PROCÉDÉ DE DÉPÔT DE MATÉRIAU PIÉZOÉLECTRIQUE EN NITRURE D'ALUMINIUM FORTEMENT DOPÉ

(43) Date of publication of application: 09.08.2023
(73) Proprietor: Lam Research Corporation, Fremont, CA 94538 (US)
(72) Inventor: DEKKERS, Jan Matthijn, 7611 CB Aadorp (NL); HOPMAN, Willem Cornelis Lambert, 7525 EH Deventer (NL); HEUVER, Jeroen Aaldert, 7545 RH Enschede (NL)
(74) Representative: Mewburn Ellis LLP

(56) References cited:
- EP-A1- 3 153 603
- CN-A- 111 599 915
- SANDU C S ET AL: "Impact of negative bias on the piezoelectric properties through the incidence of abnormal oriented grains in Al0.62Sc0.38N thin films", THIN SOLID FILMS, vol. 697, 23 January 2020 (2020-01-23), XP086102415, DOI: 10.1016/J.TSF.2020.137819
- FELMETSGER V ET AL: "Sputter Process Optimization for Al0.7Sc0.3N Piezoelectric Films", 2019 IEEE INTERNATIONAL ULTRASONICS SYMPOSIUM, 6-9 OCTOBER 2019, GLASGOW, UK, 6 October 2019 (2019-10-06), pages 2600 - 2603, XP033670935, DOI: 10.1109/ULTSYM.2019.8925576
- DELMDAHL R ET AL: "Pulsed laser deposition systems and lasers for pilot and volume production", LASER-BASED MICRO- AND NANOPROCESSING XVI, 20-24 FEBRUARY 2022, SAN FRANCISCO, CA; SPIE PROCEEDINGS, vol. 11989, 119890K, 20 February 2022 (2022-02-20), XP060155317, DOI: 10.1117/12.2606173

## Description

The invention relates to a method for manufacturing a doped wurtzite Aluminum Nitride piezoelectric thin film material, which method comprises the steps of:
- providing a deposition device, such as a pulsed laser deposition device or a physical vapor deposition device, with a target and a substrate, wherein the target material is a doped Aluminum Nitride composite, wherein the doping element is a rare earth element, preferably Scandium;
- depositing a first layer of the target material on the substrate by operating the deposition device, wherein the kinetic energy of the plasma particles being deposited is above a first threshold value; and a
- depositing a second layer of the target material on top of the first layer by operating the deposition device, wherein the kinetic energy of the plasma particles being deposited is below a second threshold value.

For the invention, the kinetic energy of the plasma particles is defined by the plasma temperature measured in electronvolts. The plasma temperature is a common measure of the thermal kinetic energy per particle.

It is known, for example, from EP 3340327 to manufacture a piezoelectric material with a pulsed laser deposition device. From this publication it is also known to apply two or more layers of the target material onto a substrate, while using different process parameters for each of the layers.

EP 3340327 teaches to use a low deposition rate for the first layer and to use a high deposition rate for the second and further layers. This ensures that the second layer has a less erratic crystal structure compared to a piezoelectric material, which has been grown using only the high deposition rate. CN 111599915 discloses growth of an AlN or AlScN seed layer and a piezoelectric AlN or AlScN layer thereon, by physical vapor deposition or pulsed laser deposition, wherein the target material is one or more of Al, Sc, AlSc, AlN or AlScN. EP 3153603 describes deposition of a doped AlN film by pulsed DC reactive sputtering, wherein a first layer is deposited using an electrical bias power, particularly greater than 70 W, and a second layer is deposited using no or a lower electrical bias power, particularly less than 250 W, using a single target formed from Al and the at least one doping element. For depositing highly Sc-doped AlN piezoelectric films by reactive magnetron sputtering, use of segmented Al-Sc targets and a two-step deposition using relatively high N₂ flow in the nucleation phase and reduced N₂ flow thereafter is taught by V. Felmetsger et al ("Sputter Process Optimization for Al0.7S0.3N Piezoelectric Films", 2019 IEEE International Ultrasonics Symposium, Glasgow, pages 2600-2603).

When a doped Aluminum Nitride composite, in particular Scandium Aluminum Nitride, is used to manufacture a piezoelectric material, it is known that by increasing the Scandium concentration, the piezoelectric response also increases (See: Morito Akiyama et. al. "Influence of growth temperature and scandium concentration on piezoelectric response of scandium aluminum nitride alloy thin films", Applied Physics Letters 95, 162107 (2009)).

However, if the doping concentration is increased to high values (>20% Sc) unwanted features start to appear on the film surface. These features are visible with a scanning electron microscope (SEM) on the surface of the deposited layer as triangular zones, which are called inverted domains. The inverted domains are known to negatively influence the properties of the Scandium Aluminum Nitride thin film. Hence it is important to suppress the amount of the inverted domains.

If the concentration of the doping element is further increased beyond a certain value (>43% prior art), then a dramatic drop in the piezoelectric response is observed. This is caused by a phase transition to a non-polar rocksalt-type structure of the Scandium Aluminum Nitride, which no longer has piezoelectric properties. Therefore it is desired to maintain the wurtzite phase at the highest doping concentration possible. The amount of inverted domains and concentration at which the dramatic drop in piezoelectric response is observed, is dependent on the interface between the substrate and the layer of target material (See: Simon Fitchner et. al. "Identifying and overcoming the interface originating c-axis instability in highly Sc enhanced AlN for piezoelectric micro-electromechanical systems" Journal of Applied Physics 122, 035301 (2017)).

In order to improve the interface between the substrate and the layer of target material it is known, using a physical vapor deposition, to apply a pre-cleaning treatment, such as etching, milling or passivation, onto the surface of the wafer or the electrode stack on which the Scandium Aluminum Nitride thin film needs to be applied. Further, a first thin layer may be applied using another target material, typically undoped AlN or Scandium doped AlN with a lower Sc concentration than the second bulk layer. This first layer acts as a template for the stabilization of the wurtzite phase of second bulk layer consisting of the highly doped Scandium Aluminum Nitride. These steps require additional (costly) equipment and slows down the thin film manufacturing process.

With these additional steps it is possible to use Scandium as a doping element up to a concentration of about 30% in commercial production facilities and up to a concentration of about 43% in laboratory settings (See: Morito Akiyama et. al. "Influence of growth temperature and scandium concentration on piezoelectric response of scandium aluminum nitride alloy thin films", Applied Physics Letters 95, 162107 (2009)).

According to theoretical calculations wurtzite Scandium Aluminum Nitride is stable up to a concentration of 56% (See: M.A. Moram "ScGaN and ScAlN: emerging nitride materials", Journal of Materials Chemistry A, 2014, 2, 6042-6050; Miguel A Caro et.al. "Piezoelectric coefficients and spontaneous polarization of ScAlN" Journal of Physics: Condensed Matter, 27 (2015) 245901). However, such high concentrations up to 56% appear at least currently not possible using a cleaning treatment and/or seeding layer with lower Sc doping.

As a result, it is an object of the invention to reduce the above mentioned disadvantages, while being able to use a deposition device, such as a pulsed laser deposition device or a physical vapor deposition device, for manufacturing a piezoelectric thin film material out of a doped Aluminum Nitride composite target.

This object is achieved according to the invention with the method according to the independent claim 1. Consequently the stress in the first layer is typically lower than the stress in the second layer

By depositing the first layer with the target material, wherein the kinetic energy of the plasma particles being deposited is above a first threshold value, i.e. a high level, the substrate is in practice cleaned and smoothed, such that the chance on formation of inverted domains as a result of the quality of the substrate is substantially reduced. When subsequently a second layer of target material is deposited, wherein the kinetic energy of the plasma particles being deposited is below a second threshold value, i.e. a low level, the second layer of target material can be grown under optimal conditions, while the chance on inverted domain formation is reduced and accordingly a higher concentration of the doping element can be used in the wurtzite Aluminum Nitride, then would be possible without the depositing of the first layer with the kinetic energy of the particles at a high level.

A further advantage of the method according to the invention is that only a single target material is used, which contributes to the quality of the manufactured piezoelectric thin film material and provides no delays in the process for exchanging target materials or the use of an additional reactor for the formation of the first layer. Also the use of a cleaning chamber that adds costs to the manufacturing equipment is prevented.

Further, the second layer of target material is applied directly onto the first layer of target material and there is no need to move the substrate to a cleaning position first, perform the cleaning treatment and then move the substrate with the cleaned substrate or electrode surface to a position in which the layer of another target material is applied. So, compared to the known physical vapor deposition method, in which three separate chambers (cleaning, first layer, and second layer using a different target material compared to the first layer) are used, the method of the invention can be used in a single chamber.

In a preferred embodiment of the method according to the invention the first layer of the target material is deposited onto the substrate without any interim treatment of the substrate. The substrate could be the wafer, any passivation layer, or could be an electrode layer.

With the invention only the process parameters are changed between the first layer and the second layer and no physical displacement of the substrate and/or the target material is required to obtain a doped Aluminum Nitride thin film.

In a further preferred embodiment of the method according to the invention the first threshold value is more than 90 eV, preferably in the range of 100 eV 160 eV. This results in a stress of the first layer of less than -400 MPa. Depositing a target material with plasma particles having such a high kinetic energy ensures for an optimal surface to grow a second layer of target material onto, which allows high concentrations of the doping element, which would otherwise not be possible as many inverted domains may form and/or a phase transition would occur, and the manufactured thin film material would have lost the piezoelectric properties.

In yet a further preferred embodiment of the method according to the invention the second threshold value is less than 90 eV, preferably in the range of 40 eV 80 eV. This results in a thin film stress of the second layer typically in the range from -400 MPa to +600 MPa. This relative low kinetic energy for the plasma particles ensures an optimal growth of the second layer of target material, which in the end will provide the desired piezoelectric properties to the thin film material.

Although, the kinetic energy with which the plasma particles arrive at the substrate is directly related to the effect achieved with the invention, in practice it proves difficult to accurately measure the kinetic energy of the plasma particles. Currently a probe is used to measure the kinetic energy of plasma particles. Such a probe needs to be positioned closely to the surface of the substrate. Furthermore, if the kinetic energy of plasma particles generated by a pulsed laser deposition device is to be measured, the very short pulses of the laser and as a consequence generated plasma, further increase the difficulty of reliably measuring the kinetic energy.

Therefore, it is a common method to derive the kinetic energy of the plasma particles from the stress generated in the layer deposited by said plasma particles. The stress can be accurately measured for example with a bow meter.

In line with the above, it is an alternative embodiment of the method according to the invention wherein the kinetic energy of the plasma particles is derived from the stress in the layer deposited by said plasma particles and wherein the kinetic energy of the plasma particles is above the first threshold value while depositing the first layer by keeping the stress in said first layer lower than -500 MPa, preferably lower than -1000 MPa.

In another alternative embodiment of the method according to the invention wherein the kinetic energy of the plasma particles is derived from the stress in the layer deposited by said plasma particles and wherein the kinetic energy of the plasma particles is below the second threshold value while depositing the second layer by keeping the stress in said second layer higher than -500 MPa, preferably in the range of -400 MPa to +600 MPa.

In a further embodiment of the method according to the invention the thickness of the first layer of the target material is in the range of 10 nm - 50 nm. The exposure of the wafer or electrode during the deposition of such a thickness of the film at high kinetic energy is sufficient to provide the necessary surface cleaning. Also, such a thickness is sufficient to provide a high quality interface with the second layer and allows for the high concentrations of the doping element, without the chance on phase transition.

In still a further embodiment of the method according to the invention the concentration of the doping element is at least 20% of the target material.
Figures 1A - 1C show the steps of the method according to the invention.
Figure 2A shows a SEM photograph of the surface of a piezoelectric thin film material using a conventional technique.
Figure 2B shows a SEM photograph of the surface of a piezoelectric thin film material using the method according to the invention.
Figure 3 shows a diagram of the piezoelectric response in relation to the concentration of a doping element.

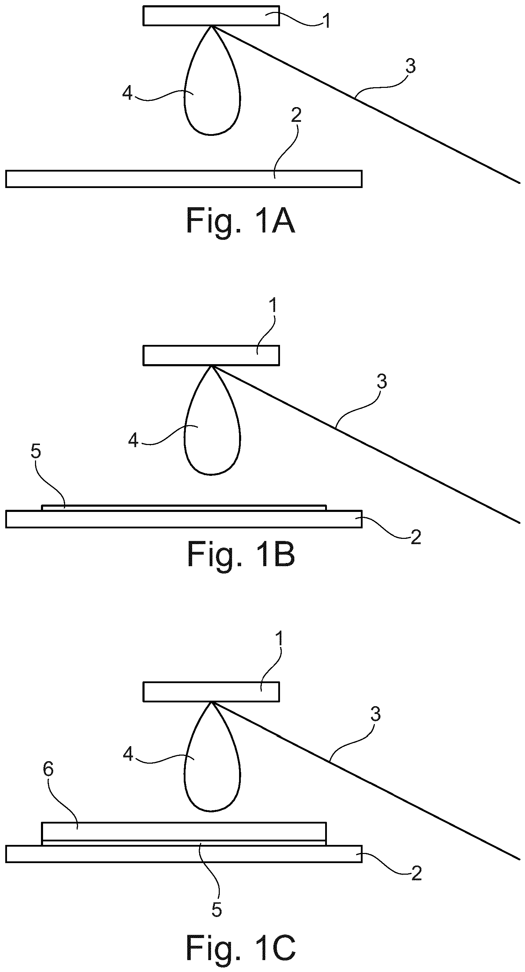

Figure 1A shows schematically a pulsed laser deposition device with a target 1 and a substrate 2. A pulsed laser 3 is directed onto the target 1, such that a plasma plume 4 is generated. In order to deposit the target material over the whole surface of the substrate 2, the laser beam 3 is for example scanned over the target 1, while the substrate 2 is rotated, or the substrate 2 is moved linear in two dimensions such that the plasma plume 4 can cover the whole surface of the substrate 2.

According to the invention a first layer 5 of target material is deposited onto the substrate 2 using a high kinetic energy above a first threshold value. (See figure 1B).

After the first layer 5 of target material is deposited, the parameters of the pulsed laser deposition device are adjusted, such that a second layer 6 of target material is deposited onto the first layer 5 using a low kinetic energy below a second threshold value. (see figure 1C).

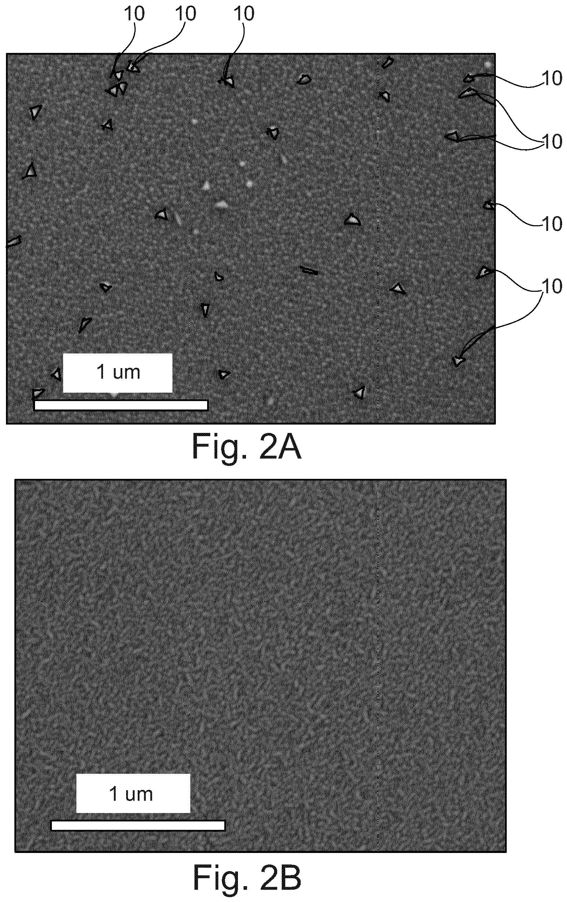

Figure 2A shows a SEM photograph of the surface of a thin film material out of Scandium Aluminum Nitride having a concentration of Scandium of 40% and which has been deposited with a pulsed laser deposition device. During deposition of the target material, the kinetic energy of the plasma particles was kept at 60 eV. The resulting thin film stress is +300 MPa (tensile). It is clear from this photograph, that zones 10 are present, which are the so-called inverted domains. This causes the properties of the thin film , such as the piezoelectric response to drop, despite the high concentration of Scandium.

Figure 2B shows a SEM photograph of the surface of a thin film material manufactured with the method according to the invention. The concentration of Scandium is equal, i.e. 40%, as with the thin film material of figure 2A. However, a first layer of target material was deposited onto the substrate, which was provided with an electrode layer, using a kinetic energy for the plasma particles at 150 eV. After about 10 nm 50 nm of this first layer was deposited, the parameters of the pulsed laser deposition device were changed, such that the kinetic energy of the plasma particles was lowered to 50 eV, close to the value used for the thin film material of figure 2A. The resulting stress of the combined thin first layer and thick second layer is +300 MPa (tensile), similar to the stress in the film of Figure 2A.

Figure 2B clearly shows, that with the method according to the invention, zones 10 are no longer present and that therefore the manufactured piezoelectric thin film material optimally benefits of the high concentration of Scandium.

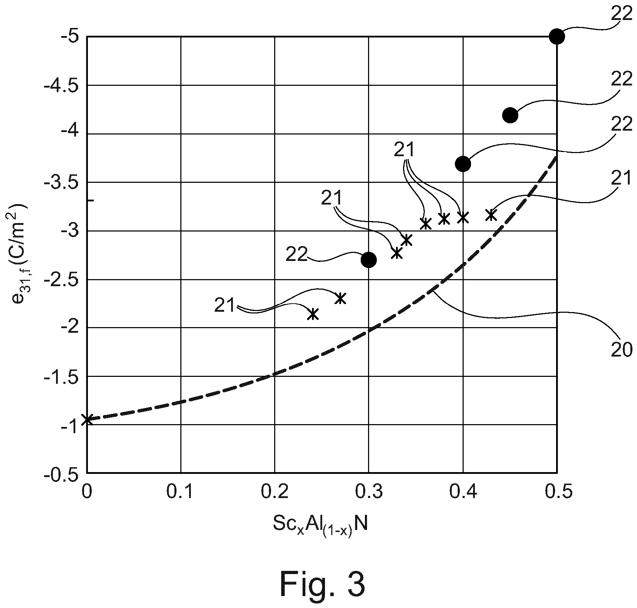

Figure 3 shows a diagram with the piezoelectric response e_{31,f} along the Y-axis and the concentration of Scandium in Aluminum Nitride along the X-axis.

The curve 20 shows the theoretical piezoelectric response dependent on the concentration of Scandium according to Miguel A Caro et.al. (2015).

The data points 21 show the results of the prior art method in which physical vapor deposition is used as suggested by Simon Fitchner et. al. (2017). It is clear that at about 35% of Scandium, the data points 21 no longer follow the theoretical curve 20 and that the piezoelectric response is affected as a result of inverted domains as shown in figure 2A, or the start of formation of rocksalt phase in the thin film.

The data points 22 show the results of the method according to the invention. For these data points 22, a first layer of Scandium Aluminum Nitride target material was deposited using a plasma particle kinetic energy of 150 eV. Then a second layer of Scandium Aluminum Nitride target material was deposited using a plasma kinetic energy of 50 eV.

It is clear from the data points 22 that even up to 50% of Scandium in the wurtzite Aluminum Nitride, the piezoelectric response was still not heavily affected by phase transition or inverted domains and that the data points 22 still are higher than when using the known physical vapor deposition technique.

## Claims

1. Method for manufacturing a doped wurtzite Aluminum Nitride piezoelectric thin film material, which method comprises the steps of:
- providing a deposition device, such as a pulsed laser deposition device or a physical vapor deposition device, with a target and a substrate, wherein the target material is a doped Aluminum Nitride composite, wherein the doping element is a rare earth element, preferably Scandium;
- depositing a first layer of the target material on the substrate by operating the deposition device, wherein the kinetic energy of the plasma particles being deposited is above a first threshold value; and
- depositing a second layer of the target material on top of the first layer by operating the deposition device, wherein the kinetic energy of the plasma particles being deposited is below a second threshold value,
wherein the first threshold value is larger than the second threshold value.

2. Method according to claim 1, wherein the first layer of the target material is deposited onto the substrate without any interim treatment of the substrate.

3. Method according to claim 1 or 2, wherein the first threshold value is more than 90 eV, preferably in the range of 100 - 160 eV.

4. Method according to any of the preceding claims, wherein the second threshold value is less than 90 eV, preferably in the range of 40 eV - 80 eV.

5. Method according to any of the preceding claims, wherein the kinetic energy of the plasma particles is derived from the stress in the layer deposited by said plasma particles and wherein the kinetic energy of the plasma particles is above the first threshold value while depositing the first layer by keeping the stress in said first layer lower than -500 MPa, preferably lower than -1000 MPa.

6. Method according to any of the preceding claims, wherein the kinetic energy of the plasma particles is derived from the stress in the layer deposited by said plasma particles and wherein the kinetic energy of the plasma particles is below the second threshold value while depositing the second layer by keeping the stress in said second layer higher than -500 MPa, preferably in the range of -400 MPa to +600 MPa.

7. Method according to any of the preceding claims, wherein the thickness of the first layer of the target material is in the range of 10 nm 50 nm.

8. Method according to any of the preceding claims, wherein the concentration of the doping element is at least 20% of the target material.

## Patentansprüche

1. Verfahren zur Herstellung eines dotierten piezoelektrischen Wurtzit-Aluminiumnitrid-Dünnfilmmaterials, wobei das Verfahren die folgenden Schritte umfasst:
- das Bereitstellen einer Abscheidevorrichtung, wie beispielsweise einer Pulslaserl-Abscheidevorrichtung oder einer physikalischen Gasphasenabscheidevorrichtung, mit einem Target und einem Substrat, wobei das Targetmaterial ein dotierter Aluminiumnitrid-Verbundstoff ist, wobei das Dotierelement ein Seltenerdelement, vorzugsweise Scandium, ist;
- das Abscheiden einer ersten Schicht des Targetmaterials auf dem Substrat durch Bedienen der Abscheidevorrichtung, wobei die kinetische Energie der Plasmapartikel, die abgeschieden werden, über einem ersten Schwellenwert liegt; und
- das Abscheiden einer zweiten Schicht des Targetmaterials auf der ersten Schicht durch Bedienen der Abscheidevorrichtung, wobei die kinetische Energie der Plasmapartikel, die abgeschieden werden, unter einem zweiten Schwellenwert liegt,
wobei
der erste Schwellenwert höher ist als der zweite Schwellenwert.

2. Verfahren nach Anspruch 1, wobei die erste Schicht aus dem Targetmaterial auf dem Substrat ohne Zwischenbehandlung des Substrats abgeschieden wird.

3. Verfahren nach Anspruch 1 oder 2, wobei der erste Schwellenwert höher als 90 eV ist, vorzugsweise im Bereich von 100 eV bis 160 eV.

4. Verfahren nach einem der vorangegangenen Ansprüche, wobei der zweite Schwellenwert niedriger als 90 eV ist, vorzugsweise im Bereich von 40 eV bis 80 eV.

5. Verfahren nach einem der vorangegangenen Ansprüche, wobei die kinetische Energie der Plasmapartikel von der Spannung in der Schicht herrührt, die durch die Plasmapartikel abgeschieden wird, und wobei die kinetische Energie der Plasmapartikel während der Abscheidung der ersten Schicht über dem ersten Schwellenwert liegt, indem die Spannung in der ersten Schicht unter -500 MPa, vorzugsweise unter -1000 MPa, gehalten wird.

6. Verfahren nach einem der vorangegangenen Ansprüche, wobei die kinetische Energie der Plasmapartikel von der Spannung in der Schicht herrührt, die durch die Plasmapartikel abgeschieden wird, und wobei die kinetische Energie der Plasmapartikel während der Abscheidung der zweiten Schicht unter dem zweiten Schwellenwert liegt, indem die Spannung in der zweiten Schicht über -500 MPa, vorzugsweise im Bereich von -400 MPa bis +600 MPa, gehalten wird.

7. Verfahren nach einem der vorangegangenen Ansprüche, wobei die Dicke der ersten Schicht des Targetmaterials im Bereich von 10 nm bis 50 nm liegt,

8. Verfahren nach einem der vorangegangenen Ansprüche, wobei die Konzentration des Dotierelements zumindest 20 % des Targetmaterials ausmacht.

## Revendications

1. Procédé de fabrication d'un matériau de film mince piézoélectrique au nitrure d'aluminium de wurtzite dopé, lequel procédé comprend les étapes consistant à :
- fournir un dispositif de dépôt, tel qu'un dispositif de dépôt par laser pulsé ou un dispositif de dépôt physique en phase vapeur, avec une cible et un substrat, dans lequel le matériau cible est un composite de nitrure d'aluminium dopé, dans lequel l'élément dopant est un élément de terre rare, de préférence du scandium ;
- déposer une première couche du matériau cible sur le substrat en faisant fonctionner le dispositif de dépôt, dans lequel l'énergie cinétique des particules de plasma déposées est supérieure à une première valeur de seuil ; et
- déposer une seconde couche du matériau cible au-dessus de la première couche en faisant fonctionner le dispositif de dépôt, dans lequel l'énergie cinétique des particules de plasma déposées est inférieure à une seconde valeur de seuil,
dans lequel la première valeur de seuil est supérieure à la seconde valeur de seuil.

2. Procédé selon la revendication 1, dans lequel la première couche du matériau cible est déposée sur le substrat sans aucun traitement intermédiaire du substrat.

3. Procédé selon la revendication 1 ou 2, dans lequel la première valeur de seuil est supérieure à 90 eV, de préférence dans la plage de 100 eV à 160 eV.

4. Procédé selon l'une quelconque des revendications précédentes, dans lequel la seconde valeur de seuil est inférieure à 90 eV, de préférence dans la plage de 40 eV à 80 eV.

5. Procédé selon l'une quelconque des revendications précédentes, dans lequel l'énergie cinétique des particules de plasma est dérivée de la contrainte dans la couche déposée par lesdites particules de plasma et dans lequel l'énergie cinétique des particules de plasma est supérieure à la première valeur seuil tout en déposant la première couche en maintenant la contrainte dans ladite première couche inférieure à -500 MPa, de préférence inférieure à -1 000 MPa.

6. Procédé selon l'une quelconque des revendications précédentes, dans lequel l'énergie cinétique des particules de plasma est dérivée de la contrainte dans la couche déposée par lesdites particules de plasma et dans lequel l'énergie cinétique des particules de plasma est inférieure à la seconde valeur de seuil tout en déposant la seconde couche en maintenant la contrainte dans ladite seconde couche supérieure à -500 MPa, de préférence dans la plage de -400 MPa à +600 MPa.

7. Procédé selon l'une quelconque des revendications précédentes, dans lequel l'épaisseur de la première couche du matériau cible est comprise entre 10 nm et 50 nm.

8. Procédé selon l'une quelconque des revendications précédentes, dans lequel la concentration de l'élément dopant est d'au moins 20 % du matériau cible.
